(19) Europäisches Patentamt / European Patent Office / Office européen des brevets

(11) **EP 2 458 041 B1**

(12) **EUROPÄISCHE PATENTSCHRIFT**

(45) Veröffentlichungstag und Bekanntmachung des Hinweises auf die Patenterteilung:
**12.08.2015 Patentblatt 2015/33**

(51) Int Cl.:
*C30B 29/42* *(2006.01)*   *C30B 11/00* *(2006.01)*
*H01L 29/36* *(2006.01)*

(21) Anmeldenummer: **12155975.1**

(22) Anmeldetag: **04.06.2008**

(54) **Kristall aus Galliumarsenid**

Gallium arsenide crystal

Cristal de arséniure de gallium

(84) Benannte Vertragsstaaten:
**AT BE BG CH CY CZ DE DK EE ES FI FR GB GR HR HU IE IS IT LI LT LU LV MC MT NL NO PL PT RO SE SI SK TR**

(30) Priorität: **06.06.2007 DE 102007026298**
**06.06.2007 US 942298 P**

(43) Veröffentlichungstag der Anmeldung:
**30.05.2012 Patentblatt 2012/22**

(62) Dokumentnummer(n) der früheren Anmeldung(en) nach Art. 76 EPÜ:
**08759007.1 / 2 106 465**

(73) Patentinhaber: **Freiberger Compound Materials GmbH**
**09599 Freiberg (DE)**

(72) Erfinder:
• **Eichler, Stefan**
**01187 Dresden (DE)**
• **Bünger, Thomas**
**21335 Lüneburg (DE)**
• **Butter, Michael**
**09633 Halsbrücke (DE)**
• **Rühmann, Rico**
**09544 Neuhausen (DE)**
• **Scheffer-Czygan, Max**
**09116 Chemnitz (DE)**

(74) Vertreter: **Prüfer & Partner GbR**
**European Patent Attorneys**
**Sohnckestraße 12**
**81479 München (DE)**

(56) Entgegenhaltungen:
WO-A2-2006/017074    JP-A- 10 338 592
US-A- 4 840 699    US-A1- 2006 278 891
US-A1- 2007 012 242

• AHMED M U ET AL: "MEASUREMENT OF ETCH PIT DENSITIES IN DIFFUSED SAMPLESS OF CDTE", JOURNAL OF CRYSTAL GROWTH, ELSEVIER, AMSTERDAM, NL, Bd. 146, Nr. 1/04, 1. Januar 1995 (1995-01-01), Seiten 136-141, XP000511855, ISSN: 0022-0248, DOI: 10.1016/0022-0248(94)00478-1
• FLADE T ET AL: "State of the art 6'' SI GaAs wafers made of conventionally grown LEC-crystals", JOURNAL OF CRYSTAL GROWTH, ELSEVIER, AMSTERDAM, NL, Bd. 198-199, 1. März 1999 (1999-03-01), Seiten 336-342, XP004170876, ISSN: 0022-0248, DOI: 10.1016/S0022-0248(98)01072-0
• HAGI Y ET AL: "Low dislocation density 3-inch Si doped GaAs crystals by Vertical Boat growth", SEMICONDUCTING AND SEMI-INSULATING MATERIALS CONFERENCE, 1996. IEEE TOULOUSE, FRANCE 29 APRIL-3 MAY 1996, NEW YORK, NY, USA,IEEE, US, 29. April 1996 (1996-04-29), Seiten 279-282, XP010213077, ISBN: 978-0-7803-3179-2

- **HASHIO K ET AL: "SIX-INCH-DIAMETER SEMI-INSULATING GAAS CRYSTAL GROWN BY THE VERTICAL BOAT METHOD", COMPOUND SEMICONDUCTORS 1998. PROCEEDINGS OF THE 25TH INTERNATIONAL SYMPOSIUM ON COMPOUND SEMICONDUCTORS. NARA, JAPAN, OCT. 12 - 16, 1998; [INSTITUTE OF PHYSICS CONFERENCE SERIES], LONDON : IOP, GB, Bd. NR. 162, Nr. 162, 12. Oktober 1998 (1998-10-12), Seiten 523-528, XP000895293, ISBN: 978-0-7503-0611-9**

Bemerkungen:
Die Akte enthält technische Angaben, die nach dem Eingang der Anmeldung eingereicht wurden und die nicht in dieser Patentschrift enthalten sind.

**Beschreibung**

Die Erfindung betrifft eine Anordnung zum Herstellen kristalliner Materialien, insbesondere solcher mit großen Dimensionen. Insbesondere betrifft die Erfindung auch die Herstellung von Halbleitern nach dem VB-Verfahren (Vertical Bridgman), beziehungsweise dem VGF-Verfahren (Vertical Gradient Freeze).

Die Wirtschaftlichkeit bei der Herstellung von Kristallen wird wesentlich vom Durchsatz, d.h. kristallisierte Masse pro Zeiteinheit) des Materials durch die Kristallisationsöfen und vom dazu notwendigen Energieverbrauch bestimmt. Viele ein- oder polykristalline Materialien werden aus der Schmelze in einem Temperaturfeld gerichtet erstarrt. Solche Verfahren werden Gradient-Freeze- (gerichtete Erstarrung) oder Bridgman-Verfahren genannt, siehe auch Wilke, K.-Th. and J. Bohm in: "Kristallzüchtung", Ed. K.-Th. Wilke., 1. Auflage ed. VEB Deutscher Verlag der Wissenschaften, 1973, 1-922.

Für viele Materialeigenschaften des zu fertigenden Kristalls wie etwa der Dotierstoffeinbau, die strukturelle Perfektion oder die elastische Verspannung ist es besonders wichtig, dass die Kristallisationsfront im Tiegel während der Erstarrung keine oder nur geringe Krümmungen aufweist. Um Krümmungen der Phasengrenzen vermeiden zu können, muss in allen Punkten einer zur Erstarrungsrichtung senkrechten Richtung gleichermaßen die axiale Wärmeflussbedingung eingehalten werden:

$$v = \left(q_{Schmelze} - q_{Kristall}\right)/\Delta h_{latent}\rho_{Kristall} .$$

Dabei bezeichnet v die axiale Kristallisationsgeschwindigkeit, q die axialen Wärmeflüsse jeweils in Schmelze und Kristall an der Kristallisationsfront, $\Delta h_{latent}$ die spezifische latente Wärme des Phasenübergangs und $\rho_{Kristall}$ die Massendichte des erstarrten Materials. Der Wärmefluss im Kristall berechnet sich als Produkt von Wärmeleitfähigkeit $\lambda$ und Temperaturgradient grad(T). Näherungsweise kann auch $\Delta T/\Delta x$ angegeben werden, wenn x die axiale Koordinate in Erstarrungsrichtung ist. Mit der Näherung eines verschwindenden Wärmeflusses in der Schmelze, $q_{Schmelze} = 0$, ergibt sich für die Wachstumsgeschwindigkeit eine obere Grenze:

$$v \le \left(\lambda/\Delta h_{latent}\rho_{Kristall}\right)\cdot grad(T) .$$

Der Temperaturgradient kann allerdings für viele Materialien wegen der auftretenden thermoelastischen Spannungen nicht beliebig groß gewählt werden. Insbesondere für länger werdende Kristalle wird dann die Wachstumsgeschwindigkeit notwendig kleiner. In diesem Fall wird der Wärmewiderstand des Kristalls mit fortschreitender Kristallisation immer größer und die ableitbare latente Leistung, d.h. die latente Wärme pro Zeiteinheit, nimmt ab. Dies begrenzt wiederum auch die Wachstumsgeschwindigkeit für lange Kristalle.

Aus ökonomischen Gründen insbesondere auch des Materialdurchsatzes in Kristallisationsöfen ist es folglich wenig sinnvoll, die Kristalllänge über bestimmte materialabhängige Grenzen zu erhöhen. Der Materialdurchsatz könnte dagegen durch die Vergrößerung der Fläche, auf der das Material gleichzeitig kristallisiert, erhöht werden. Dabei wird die latente Leistung proportional zur Kristallisationsfläche größer, jedoch erhöht sich auch die Wärmeableitung von der Phasengrenze flächenproportional.

Oft werden für die Weiterverarbeitung des kristallinen Materials zu elektronischen Bauelementen oder integrierten Schaltkreisen, Solarzellen, optischen Bauelementen usw. auch nur bestimmte standardisierte Materialgrößen benötigt. Eine beliebige Vergrößerung der Kristallisationsfläche im Tiegel kommt daher aus Gründen einer fehlenden entsprechenden Nachfrage nicht ohne weiteres in Betracht.

Es ist bekannt, nicht einen größeren Materialblock zu kristallisieren, sondern jeweils parallel zueinander mehrere formangepasste dünnere Kristalle herzustellen. Solche Bridgman-artigen Methoden sind für optische Materialien wie Seltenenerde-Fluoride gemäß der US 3, 796, 552 A oder für Szintillatorkristalle wie Bariumfluorid gemäß der EP 0, 130, 865 A1 bekannt. Hier liegen jedoch kleine Verhältnisse der Durchmesser zu den jeweiligen Längen der Kristalle vor.

Für im Vergleich dazu größere Kristalle, die in mikro- und opto-elektronischen, photovoltaische oder optischen Anwendungen Platz finden sollen, sind entsprechende Lösungen bisher nicht angestrebt worden. Die große Herausforderung liegt nämlich darin, das Temperaturfeld zu jedem Zeitpunkt der Kristallisation so zu auszubilden, dass wichtige Eigenschaften wie z.B. der elektrische Widerstand, die Ladungsträgerbeweglichkeit, die Punktdefektkonzentrationen, die strukturelle Perfektion, elastische Spannungen, der optische Brechungsindex, die Reflektivität usw. bezüglich der Homogenität quer durch den Kristall den Zielvorgaben der Hersteller jeweiliger Anwendungen entsprechen.

Für Halbleiterkristalle, die im weiteren Fertigungsprozess zu Halbleiterwafern verarbeitet werden, spielt die radiale Homogenität eine für die Bauelementeprozessierung besonders wichtige Rolle. So sollen Parameter wie der spezifische elektrische Widerstand, die Ladungsträgerbeweglichkeit, Dotierstoff- bzw. Fremdstoffkonzentration, oder die Restspannung besonders homogen über den Wafer verteilt sein.

Hinsichtlich einkristalliner Materialien bestehen weiter erhöhte Anforderungen darin, die genaue Kristallorientierung zu berücksichtigen. Meist wird hier ein Keimkristall vorgelegt werden, der die Kristallrichtung des zu wachsenden Kristalls festlegt. Verfahren, bei denen der Einkristall durch spontane Keimbildung und nachfolgender Keimauswahl erzeugt wird, scheiden aus materialökonomischen Gründen oftmals aus.

Die Schwierigkeit des Ankeimens an einen Keimkristall besteht darin, das Temperaturfeld derart auszubilden, dass das aufgeschmolzene Material den Keim berührt und der Keim dann leicht zurückgeschmolzen wird. Für Bridgman- oder Gradient-Freeze-Verfahren ist es üblich, die Anordnung der Wärmequellen und -senken so zu wählen, dass das gewünschte Temperaturfeld erzeugt werden kann. Bei zunehmend großen Aufbauten wird es nun zusätzlich notwendig, so genannte Liner mit entsprechenden thermischen Eigenschaften derart anzuordnen, dass ein Temperaturfeld auch über größere Gebiete hin geformt werden kann, wie es etwa in den Druckschriften EP 1, 147, 248 und US 6,712,904 beschrieben ist.

In der Druckschrift Flade et al.: "State of the art 6" SI GaAs wafers made of conventionally grown LEC-crystals", Journal of Crystal Growth 198/199, 1999, S. 336-342 ist eine Messung der Ätzgrubendichte an Galliumarsenidwafern beschrieben, wobei an einem speziellen Beispiel eine Standardabweichung von 17 % dokumentiert ist. Die Messung wird genauer im Rahmen einer 9-Punktemessung gemäß der standardisierten Vorschrift ASTM F1404 mit einer lateralen Auflösung von 300 $\mu$m durchgeführt.

In der Druckschrift Hagi et al.: "Low dislocation density 3-inch Si doped GaAs crystals by Vertical Boat Growth", Semiconducting and Semi-insulating Materials Conference 29.4.-3.5.1996, IEEE Toulouse, S. 279-282 ist ebenfalls eine Messung der Ätzgrubendichte von Galliumarsenidwafern beschrieben, allerdings nur für 3"-Wafer. Eine Messvorschrift ist nicht angegeben.

Der Erfindung liegt folglich unter anderem eine Aufgabe zugrunde, die Wirtschaftlichkeit der Kristallherstellung zu verbessern, insbesondere den Materialdurchsatz in Kristallisationsöfen zu erhöhen.

Ferner liegt ihr die Aufgabe zugrunde, die Qualität der hergestellten Kristalle hinsichtlich der Homogenität der für die jeweiligen Anwendungen insbesondere im mikro- und opto-elektronischen Bereich wichtigen Eigenschaften zu verbessern.

Diese und weitere Aufgaben werden jeweils gelöst durch einen Kristall aus Galliumarsenid mit den Merkmalen der Ansprüche 1 beziehungsweise 3.

Weitere vorteilhafte Ausgestaltungen der Erfindung sind den abhängigen Ansprüchen zu entnehmen.

Die Erfindung soll nun anhand von Ausführungsbeispielen mit Hilfe einer Zeichnung näher erläutert werden. Darin zeigen:

Fig. 1 :   eine Anordnung mit nebeneinander positionierten Tiegeln in einem VGF-Ofen (Vertical Gradient Freeze) mit äußerem Druckkessel;

Fig. 2:   eine Anordnung ähnlich Fig. 1, bei der jedoch die Tiegel jeweils in gasdichte Druckbehälter gefasst sind;

Fig. 3:   eine Anordnung ähnlich Fig. 1, bei der jedoch ein VB-Ofen (Vertical Bridgman) realisiert ist;

Fig. 4:   ein Querschnitt senkrecht zur Längsachse durch eine geometrisch beispielhafte Anordnung von 3 kreisrunden Tiegeln;

Fig. 5:   wie Fig. 4, jedoch mit 4 runden Tiegeln;

Fig. 6:   wie Fig. 4, jedoch mit 4 quadratische Tiegeln;

Fig. 7:   wie Fig. 4, jedoch mit einer konzentrischen Anordnung von 7 runden Tiegeln;

Fig. 8:   wie Fig. 4, jedoch mit einer matrixartigen, hexagonalen Anordnung von 12 runden Tiegeln;

Fig. 9:   wie Fig. 7, jedoch mit einem in der Mitte verkleinert ausgeführten Tiegel;

Fig. 10:   wie Fig. 1, wobei für die äußeren Mantelheizer Vorrichtungen zur Erzeugung magnetischer Wanderfelder zur gezielten Bildung von Konvektion in den Tiegeln vorgesehen sind, gemäß einen ersten Ausführungsbeispiel der Erfindung;

Fig. 11: wie Fig. 1, wobei zusätzlich zu den äußeren Mantelheizern in der Mitte des Ofens Vorrichtungen zur Erzeugung von magnetischen Wanderfeldern vorgesehen sind, gemäß einem zweiten Ausführungsbeispiel der Erfindung;

Fig. 12: wie Fig. 5, wobei gemäß einem dritten Ausführungsbeispiel Füllköper in die Tiegelzwischenräume eingebracht sind;

Fig. 13: wie Fig. 12, wobei die Tiegel jeweils einzeln in gasdichte Druckbehälter gefasst sind;

Fig. 14: wie Fig. 5, wobei gemäß einem vierten Ausführungsbeispiel der Erfindung Zwischentiegel in die Zwischenräume zwischen den Erstarrungstiegeln eingebracht sind;

Fig. 15: wie Fig. 14, wobei die Tiegel gemeinsam in einem Druckkessel des Ofens eingerichtet sind.

Es werden in den Ausführungsbeispielen der Erfindung Anordnungen 1 beschrieben, mit denen beispielhaft Einkristalle aus III-V-, IV-IV- und II-VI-Verbindungen wie z.B. Galliumarsenid (GaAs, Indiumphosphid (InP), Cadmiumtellurid (CdTe), Cadmiumquecksilbertellurid und verschiedene Antimonide sowie Elementhalbleiter wie Germanium (Ge)und Silizium (Si) hergestellt werden können. Außerdem können polykristalline Materialien wie z.B. Silizium (Si) für photovoltaische Anwendungen erstarrt werden.

Mehrere Tiegel 14 werden dabei nebeneinander so angeordnet, dass eine entsprechende Anzahl großer Kristalle mit Durchmessern bzw. - im Fall von rechteckigen Tiegelquerschnitten: Kantenlängen - von bis zu 125 mm oder mehr (beispielsweise zur Herstellung von 8"-Kristallen und daraus hergestellten Wafern) gleichzeitig in ein und derselben Anordnung bzw. in ein und demselben Temperaturfeld wächst, das in der Anordnung 1 erzeugt wird.

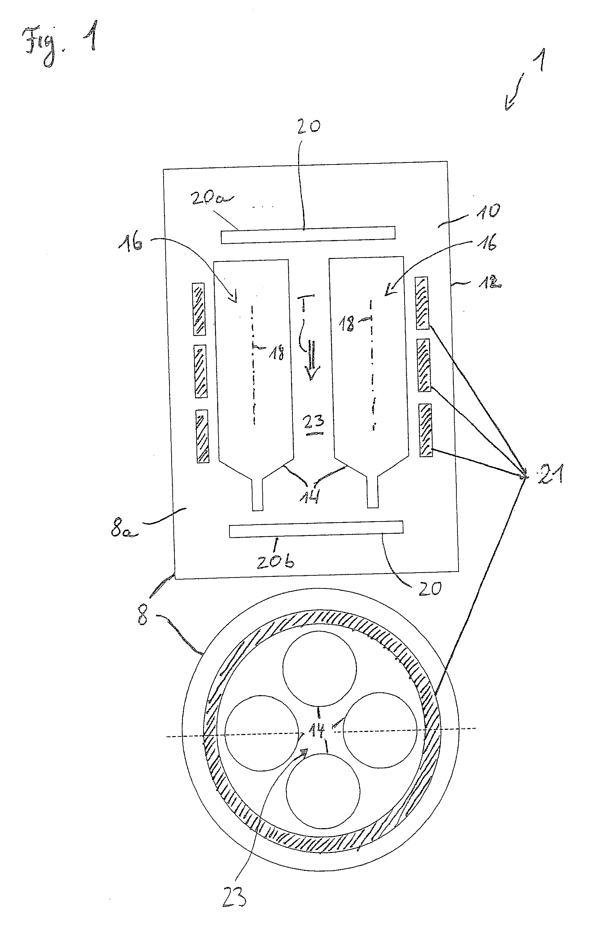

Eine mit der Erfindung zu verwendende Anordnung 1 ist im Längsschnitt (oben) und im Querschnitt (unten) in Figur 1 dargestellt. Die Schnittachse ist unten durch eine gestrichelte Linie angedeutet. Die Anordnung 1 umfasst einen VGF-Ofen 10 mit einer hier zylindrischen Ofenwand 12, in welchem mehrere Tiegel 14 angeordnet sind. Die Tiegel 14 nehmen eine Schmelze 16, beispielsweise aus Galliumarsenid auf. Durch eine Anordnung von Heizelementen 20 wird ein gerichtetes Temperaturfeld T erzeugt, das im Wesentlichen innerhalb der Zeichenblattebene in Fig. 1 zu den Längsachsen 18 der Tiegel 14 parallel steht.

Die Heizelemente 20 umfassen einen oder mehrere Deckel- 20a und Bodenheizer 20b, welche im Betrieb mit einem gegenseitigen Temperaturunterschied zur Bildung des Temperaturfelds T eingestellt werden. Die Anordnung kann ferner Mantelheizer 21 aufweisen, die einen senkrecht zum Temperaturfeld T gerichteten Wärmefluss unterbinden und generell das Temperaturniveau in einer Umgebung um den Schmelzpunkt (GaAs: etwa 1238 °C) herum halten. Sie umgeben also die Gesamtheit der Tiegel 14 als solche.

Die Tiegel 14 stehen vorzugsweise mit ihrer Längsachse 18 parallel zueinander und überlappen sich in Bezug auf eine Höhenposition in Richtung des Temperaturfelds T. Die Boden- und Deckelheizer 20a, 20b besitzen eine Ausdehnung, die ausreicht um die Gesamtheit der Tiegel zwischen sich aufzunehmen bzw. abzudecken, um insoweit eine bestmögliche Homogenität zu erzielen. Die Boden- und Deckelheizer 20a, 20b sind beispielsweise u.a. aus CFC gefertigt und besitzen hervorragende Wärmeleiteigenschaften. Z.B. beträgt die Ausdehnung der Boden- und Deckelheizer 20a, 20b das 1,5- bis 2-fache der nahe beieinander zusammengestellten Tiegel 14.

Das oben beschriebene Temperaturfeld T kann in einem wassergekühlten und bei Bedarf vakuum- und druckdichten Behälter 8 (Druckkessel) erzeugt werden, welcher in seinem Innenraum 8a die Vielzahl der Tiegel 14 aufnimmt. Die in Fig. 1 gezeigte Ofenwand 12 ist in diesem Beispiel folglich gas-, vakuum- und druckdicht.

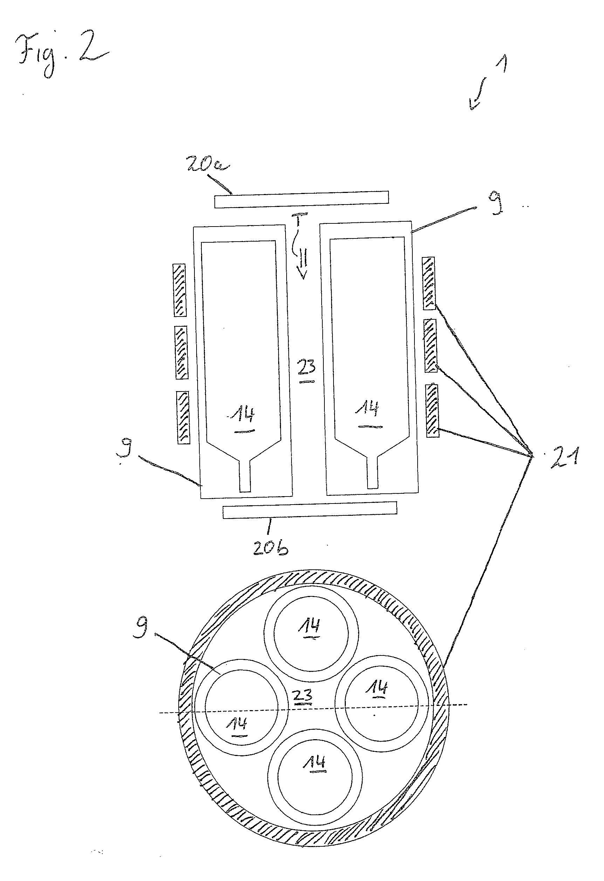

Eine alternativ im Rahmen der Erfindung zu verwendende Anordnung gemäß Fig. 2 sieht vor, insbesondere für Materialen mit erhöhten Dampfdruck jeden einzelnen der Vielzahl von Tiegel 14 mit einem druck- und gasdichten Behälter 9 (sogenannte Ampullen) zu umgeben und das Temperaturfeld T von außen aufzuprägen. Beide Methoden sind eher sogenannten "gradient freeze" Verfahren zuzuordnen.

Die Erfindung wird bevorzugt mit dem VGF-Verfahren eingesetzt. Tiegel und Heizer werden relativ zueinander nicht verfahren. Durch gezielte Steuerung der Leistungsversorgung der Heizer wird das Temperaturfeld entsprechend dem Vorstoß der Kristallisationsfront angepasst.

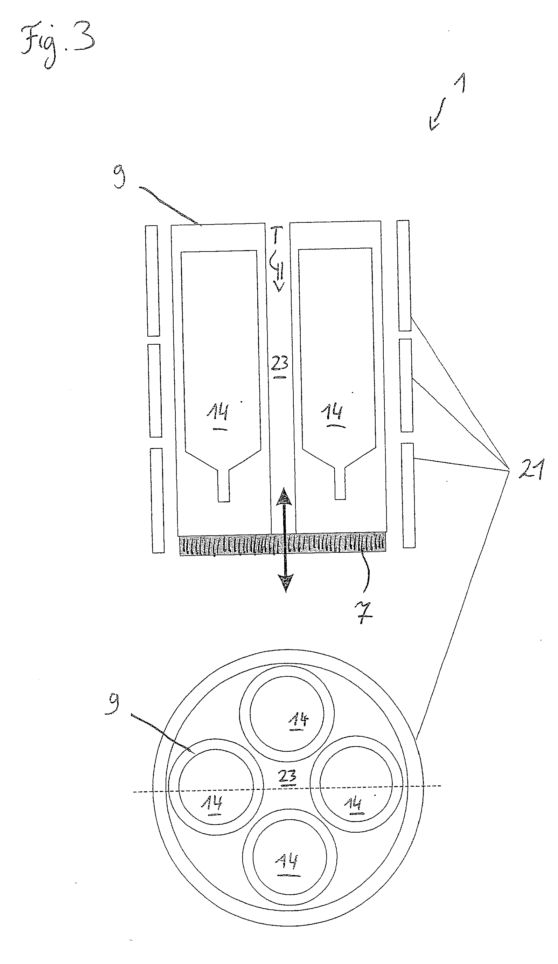

Im Unterschied dazu werden bei Bridgman-artigen Verfahren (z.B. Vertical Bridgman, VB) die Tiegel - unter Umständen auch in einem gasdichten Behälter verschlossen - in einem ortsfesten Temperaturfeld T axial, d.h. in Feldrichtung, verschoben (vgl. Fig. 3). In der in Figur 3 gezeigten Anordnung 1, die auch mit der Erfindung realisiert werden kann, wird dies anhand einer schematisch dargestellten, verfahrbaren Halterung 7 und eines Motors (nicht dargestellt) bewerkstelligt.

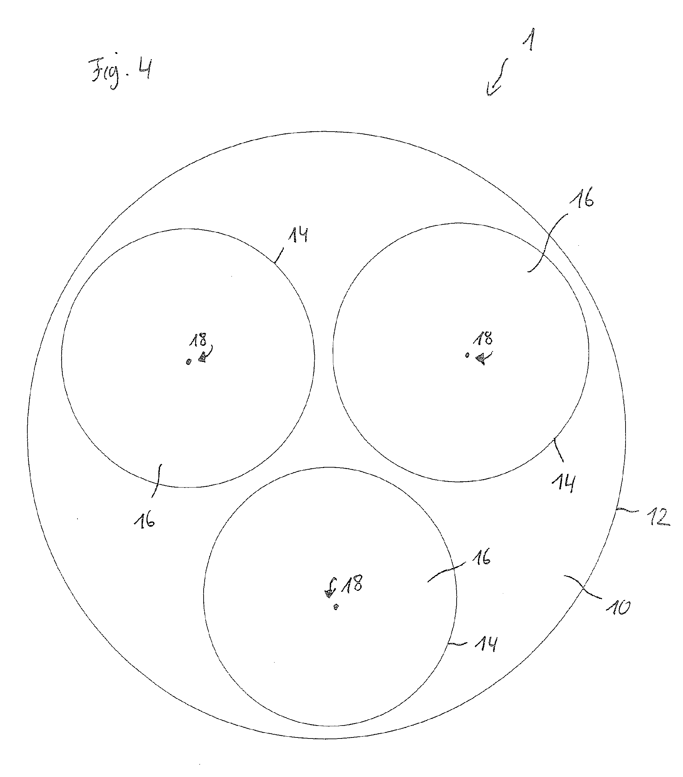

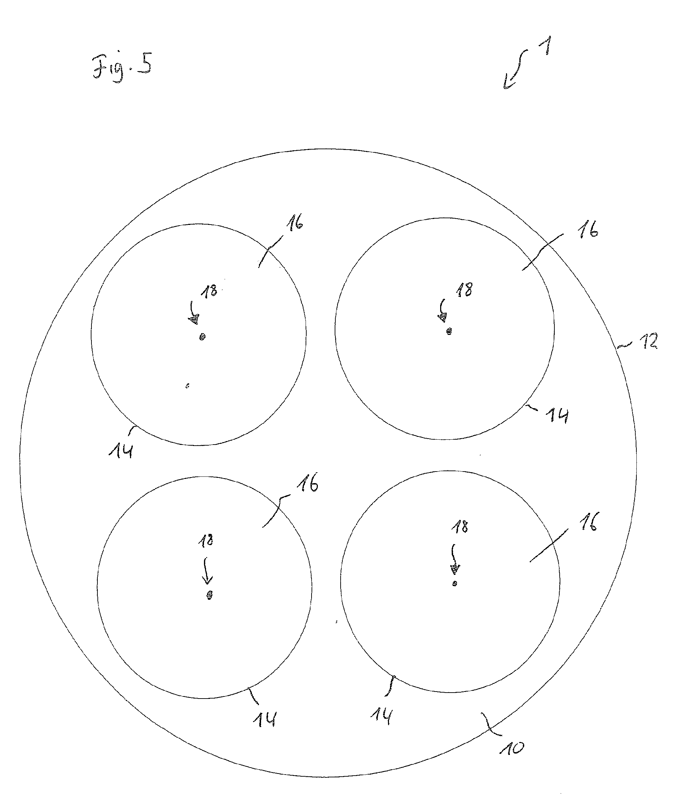

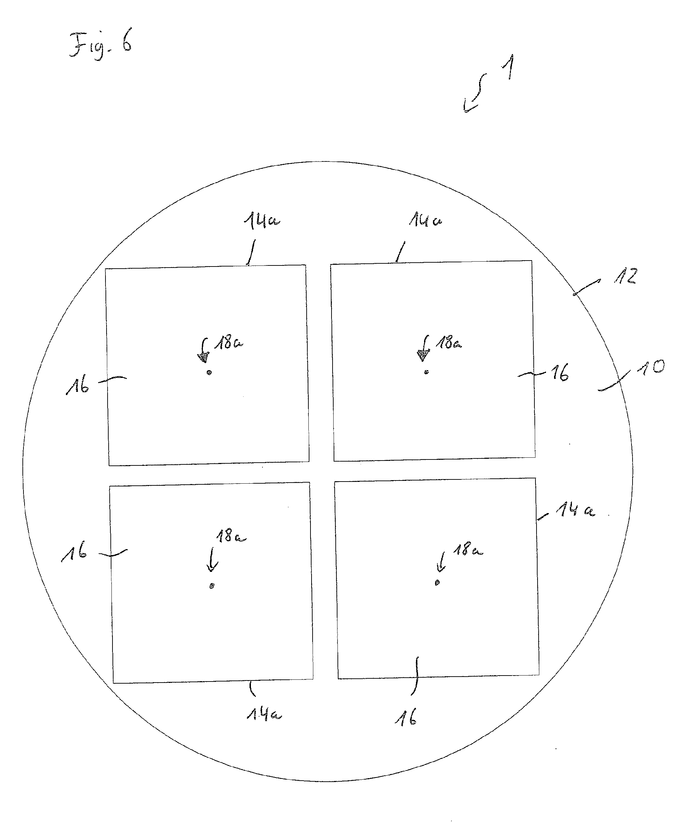

Die Figuren 4 bis 9 zeigen weitere beispielhafte Querschnitte von Tiegelanordnungen (schematische Draufsicht), die ebenfalls im Zusammenhang mit den Ausführungsbeispielen der Erfindung eingesetzt werden können: Form, Anzahl und geometrische Anordnung der Tiegel 14 können bei nach Bedarf variiert werden. Figur 4 zeigt eine Anordnung 1 mit drei Tiegeln, Fig. 5 die oben beschrieben Form mit vier Tiegeln. Für photovoltaisches Material ist die Anordnung von Tiegeln mit quadratischen Querschnitten denkbar (Fig. 6). In diesem Fall kommen matrixartige Anordnungen mit n•m (n = 1, 2, 3,..; m = 2, 3, 4,...) Tiegeln 14a in Betracht. Die Längsachse wird in Figur 6 mit dem Bezugszeichen 18a angedeutet.

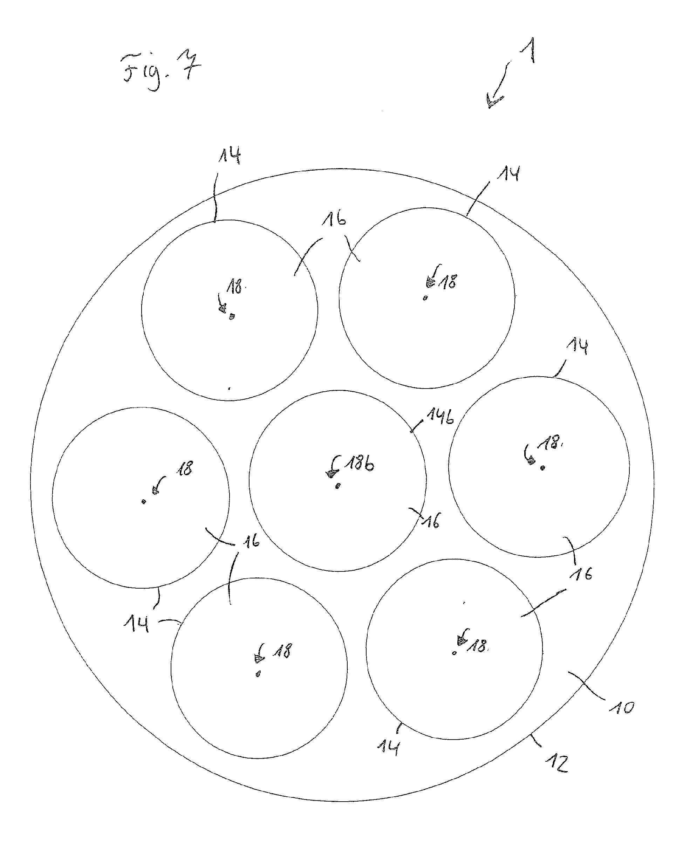

Figur 7 zeigt sechs konzentrisch um einen mittleren Tiegel 14b gruppierte Tiegel 14. Die Anordnung ist rotationssymmetrisch um eine Achse 18b, die in Fig. 7 senkrecht zur Zeichenebene steht. Die Rotationssymmetrie ermöglicht eine leichtere Handhabung von Inhomogenitätseffekten, weil die äußeren Bedingungen, die auf die Tiegel 14 auf ein und demselben Kreis einwirken, nahezu die gleichen sind.

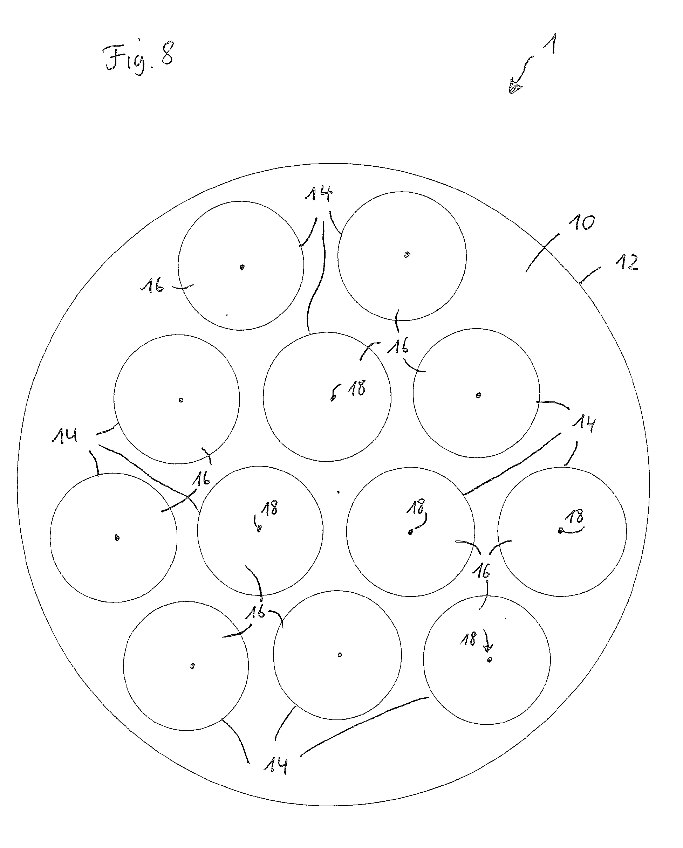

Figur 8 zeigt demgegenüber eine matrixartige, hexagonale Anordnung 1 on Tiegeln 14. Hier wird eine sehr hohe Packungsdichte der Tiegel 14 erreicht.

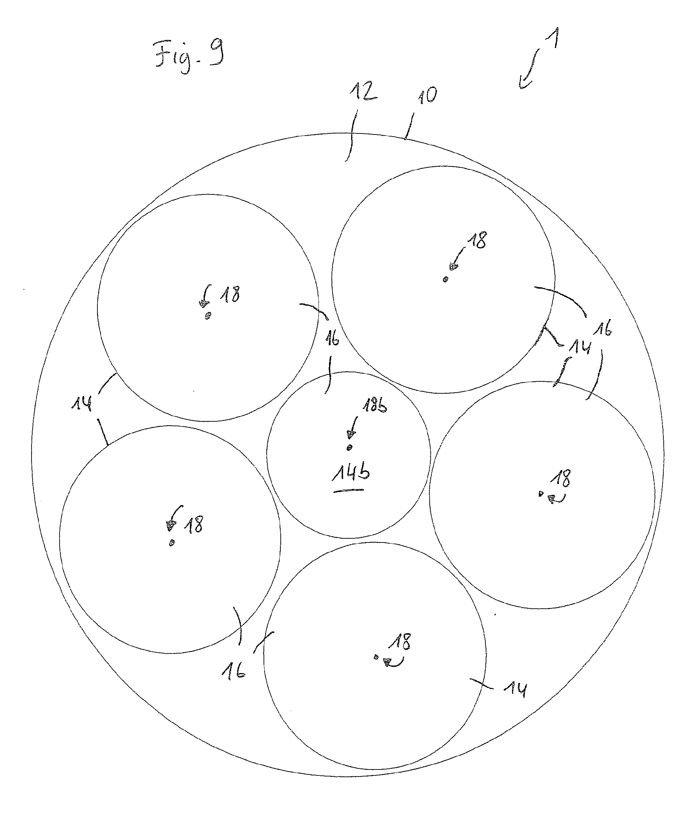

Das Verhältnis der Länge zum Durchmesser einzelner Tiegel ist jeweils größer als 1:1. Die jeweiligen Längen und Durchmesser der Tiegel 14 im Vergleich zueinander sind bevorzugt identisch, jedoch kann der Durchmesser der Tiegel auch unterschiedlich sein, wie es in Fig. 9 mit Bezug auf den mittleren Tiegel 14b gezeigt ist. Die Durchmesser der Tiegel gemäß den Ausführungsbeispielen können 3", 4", 6", 8" oder größere Werte betragen. Natürlich sind auch Zwischenwerte des Durchmessers möglich.

Die Gesamtanordnung besitzt einen Durchmesser, der viel größer ist als deren Höhe, die wiederum im Wesentlichen mit der Länge der Tiegel skaliert.

Die Tiegelwände können in allen hier beschriebenen Ausführungsbeispielen aus pBN gefertigt sein (A.G. Fischer, J. of Electr. Chem. Society, 20(4), 1970; S.E. Blum et al., Brief Communications of the Electr. Chem. Society, 20(4), 1972). Die Erfindung ist jedoch nicht darauf beschränkt.

Ein Ziel ist es nun, das Temperaturfeld derart auszubilden, dass die gewünschten Materialeigenschaften auch dann erhalten werden, wenn viele große Kristalle simultan gezüchtet werden sollen. Konkret werden hier dazu folgende Bedingungen erfüllt:

1. die Ankeimposition liegt für alle Tiegel in der gleichen Höhe in Bezug auf die Richtung des Temperaturfelds liegt, damit ein stabiles und reproduzierbares Ankeimen möglich ist.

2. ein axialer Wärmefluss (axial: in Richtung des Temperaturgradienten) wird derart ausgebildet, dass die Erstarrungsfront im wesentlichen flach und zudem möglichst symmetrisch zur Achse des jeweiligen Kristallisationstiegels verläuft, um einerseits die auftretenden thermoelastischen Spannungen gering und um andererseits die Variation der wesentlichen Eigenschaften eines nachfolgend aus dem Kristall zu fertigenden Wafers (nämlich der elektrische Widerstand, die Dotierstoffkonzentration, der Restspannungsgehalt, die Versetzungsdichte etc.) in akzeptablen Grenzen zu halten.

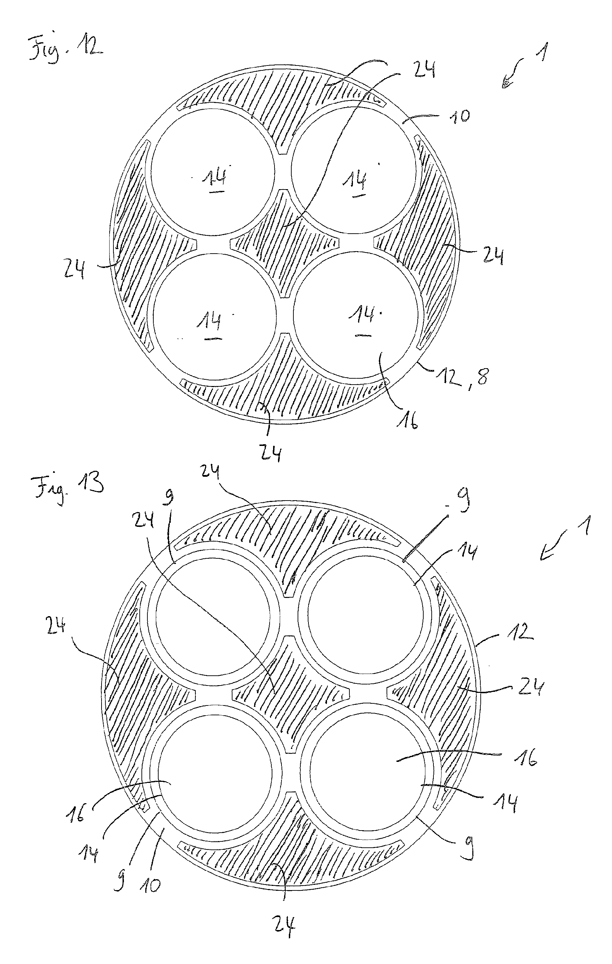

Ein erstes, mit jeder der in den Fig. 1-9 gezeigten Anordnungen kompatibles Ausführungsbeispiel weist eine Einrichtung zur Homogenisierung des Temperaturfelds in einer Ebene senkrecht zur Erstarrungsrichtung auf, die wärmetechnisch optimierte Bauteile umfasst. Eine Ausführungsform ist in Fig. 12 gezeigt. Diese Bauteile können als Füllkörper 24 ausgebildet sein.

Die Räume zwischen den Tiegeln werden mit diesen speziellen Füllkörpern 24 ausgefüllt. Insbesondere sind die Füllköper 24 in diesem Ausführungsbeispiel in ihrer Form an die Zwischenräume 23 (vgl. z.B. Fig. 1-3) zwischen den Tiegeln angepasst. Es handelt sich hier bevorzugt um eine Vielzahl physisch getrennt voneinander vorliegender Füllkörper 24. Jeder ist einzeln einsetzbar bzw. entnehmbar. Durch Auswahl von Füllkörpern unterschiedlicher Materialeigenschaften hinsichtlich Wärmeleitfähigkeit kann gezielt auf den Wärmefluss in der Gesamtanordnung Einfluss genommen werden.

Durch die Füllkörper 24 wird zum einen die unerwünschte Wärmeübertragung durch turbulente Gaskonvektion, die bei Züchtungstechnologien unter Verwendung von erhöhten Inertgasdrücken auftritt, und eine gegebenenfalls unkontrollierbare Wärmestrahlung unterdrückt. Das Temperaturfeld wird so einzig durch den Mechanismus der Wärmeleitung zwischen Wärmequellen, nämlich den Heizern, und die latente Wärme des Phasenübergangs sowie den Wärmesenken, nämlich den gekühlten Anlagenwänden 12 bestimmt.

Durch die Füllköper 24 kann die Brechung der in Einzel-Tiegelanlagen üblichen Rotationssymmetrie bezüglich der Tiegellängs- oder Rotationsachse 18 ausgeglichen werden. Als Materialien für Füllkörper 24 eignen sich insbesondere solche, deren Wärmeleitfähigkeit an die der zu erstarrenden Substanz angepasst ist. Dazu können beispielsweise Graphite, Keramiken oder Faserwerkstoffe mit angepasster Dichte verwendet werden.

Eine besondere Ausgestaltung sieht vor, Füllkörper 24 mit anisotropen Wärmeleitfähigkeiten einzusetzen. In (axialer) Richtung des Erstarrungsfortschritts entspricht hier die Wärmeleitfähigkeit derjenigen des zu erstarrenden Materials. Senkrecht dazu (also in der in Fig. 4-9 gezeigten Ebene bzw. in radialer Richtung) ist die Wärmeleitfähigkeit in den Füllkörpern 24 vergleichsweise hoch. Dadurch werden Temperaturgradienten in radialer Richtung von der Rotationsachse 18 aus gesehen unterdrückt.

Faserwerkstoffe oder Verbundwerkstoffe mit speziell ausgerichteten Fasern (Keramikfaserwerkstoffe oder Kohlenfaser verstärkte Werkstoffe) oder lameliierte Verbundwerkstoffe erfüllen diese Forderungen. Die grundsätzlichen Eigenschaften solcher Stoffe sind dem die Erfindung nacharbeitenden Fachmann bekannt.

Insbesondere kann auch Graphit mit solchen Eigenschaften hergestellt werden. Dazu gehören beispielsweise hochtemperaturresistente Graphitfilze oder -folien mit Wärmeleitfähigkeiten von 20-40 W/mK in der Folienebene und 2-10 W/mK in der Richtung senkrecht dazu. Solche Filze lassen sich zu Stapeln schichten. Die Materialien können auch u.a. durch CVD-Prozesse zu unterschiedlicher Dichte verdichtet werden, welches dann auch wieder zu unterschiedlichen Wärmeleiteigenschaften führt. In Kombination - oder auch als spezieller "Gradientenwerkstoff" gefertigt - gibt die Schichtausrichtung der Folien höherer Dichte auch die Richtung des stärksten Wärmeflusses an. Anders ausgedrückt: stärker isolierende Zwischenschichten mindern den Wärmefluss senkrecht zu der betreffenden Schicht.

Graphitmaterialien mit anisotropen Wärmeleiteigenschaften sind z.B. erhältlich von den Firmen Calcarb Ltd, Bellshill, North Lanarkshire, Scotland, UK, oder Schunk Graphite Technology, LLC, Menomonee Falls, Wisconsin, US, oder SGL Carbon AG, Wiesbaden, Hessen, DE.

Die Anordnung gemäß dem ersten (und dem folgenden zweiten) Ausführungsbeispiel kann zum Beispiel wie bei einem Tamann-Stöber-Aufbau für die Durchführung des VGF-Verfahrens konfiguriert sein, so wie es weiter unten im Zusammenhang mit dem dritten Ausführungsbeispiel noch beschrieben wird.

Figur 13 zeigt eine Modifikation des Beispiels aus Figur 12, wobei die Tiegel 14 jeweils einzeln in gas- und druckdichten bzw. vakuumdichten Behältern 9 (Ampullen) angeordnet sind. Die Füllkörper 24 füllen dabei die Zwischenräume zwischen den Ampullen aus.

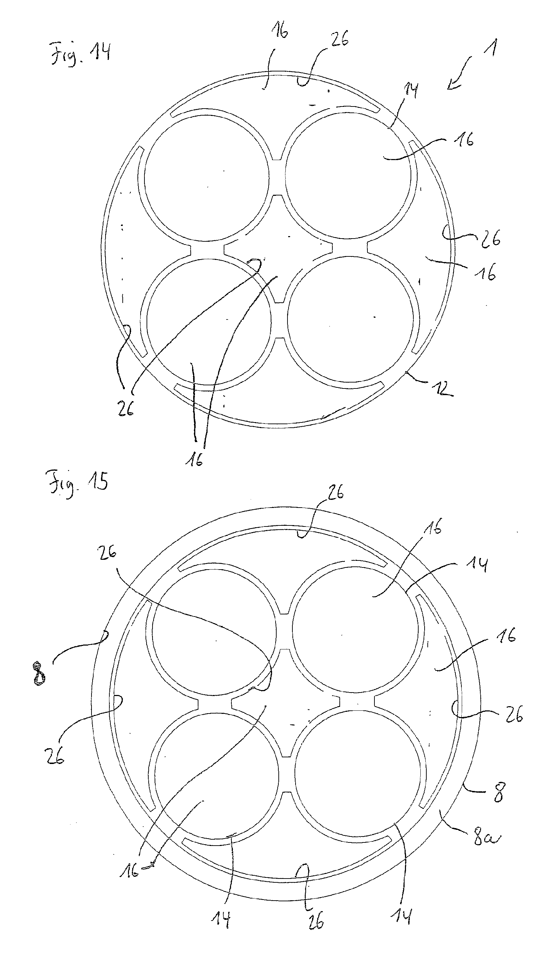

Ein zweites, zum vorhergehenden Ausführungsbeispiel ähnliches Ausführungsbeispiel ist in Fig. 14 gezeigt und bezieht sich auf das Einbringen von Zwischentiegeln 26 in die Zwischenräume 23 zwischen den Tiegeln 14.

Die Räume zwischen den Kristallisationstiegeln werden mit speziell geformten Tiegeln 26, die das gleiche oder ähnliches Material wie dasjenige enthalten, das auch im (Haupt-)Tiegel 14 kristallisieren soll, hier als Fülltiegel bezeichnet, ausgefüllt. Hier ergibt sich der besondere Vorteil nahezu gleicher wärmephysikalischer Parameter. Das Material in den Fülltiegeln kann wieder benutzt werden (als Schmelze) und altert kaum.

Beispielsweise kann die Schmelze 16 in den Haupttiegeln 14 im Wesentlichen aus GaAs enthalten und in den Zwischentiegeln 16 ebenfalls GaAs umfassen.

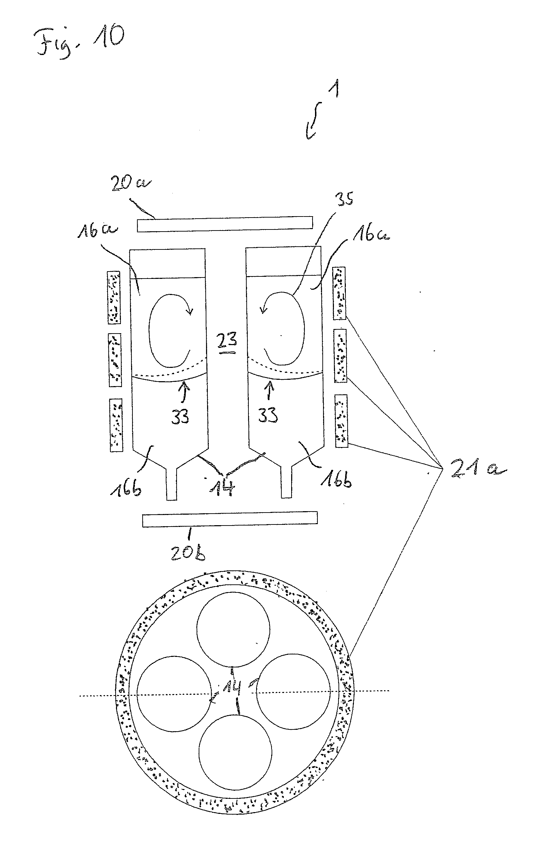

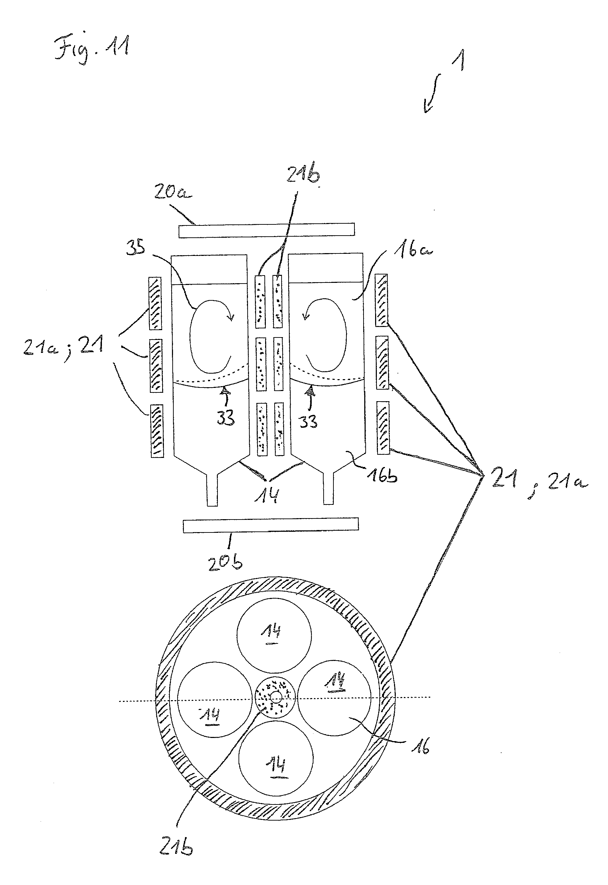

Ein weiterer Vorteil besteht darin, dass das Material in den Fülltiegeln ebenfalls erstarrt und so in direkter Nachbarschaft zu den wachsenden Kristallen latente Wärme frei wird. Ein derartiges vertikales Temperaturprofil unter Berücksichtigung der latenten Wärme der eigentlichen Schmelze kann von anderweitigen Füllstoffen kann durch andere Füllstoffe als das Schmelzmaterial selbst nur schwer widergespiegelt werden. Unerwünschte radiale Wärmeflüsse können so kompensiert werden. Im Ergebnis kann die Phasengrenzdurchbiegung 33 (siehe Figur 10 oder 11) mit Vorteil verringert werden.

Das erste und zweite Ausführungsbeispiel ist mit den in den Fig. 1-9 gezeigten Anordnungen von Tiegeln 14 im Ofen 10 kompatibel und kann erfindungsgemäß entsprechend abgewandelt werden.

Ein drittes Ausführungsbeispiel ist in Fig. 10 gezeigt. Das dritte Ausführungsbeispiel sieht als besonderes Merkmal eine Vorrichtung 21a zur Erzeugung magnetischer Wanderfelder vor. Aufgrund der Eigenschaften des Schmelzmaterials spricht dasselbe auf solche Felder an, so dass eine Konvektion in den Schmelzen der einzelnen Züchtungstiegeln 14 hervorgerufen werden kann. Die Konvektionen können dem durch die Parallelanordnung der Tiegel verursachten Symmetriebruch entgegenwirken.

In dem Ausführungsbeispiel der Fig. 10 ist eine Anordnung zur VGF-Züchtung von GaAs in einem Tammann-Stöber-Aufbau gezeigt (zum Tamann-Stöber-Aufbau: siehe Wilke, K.-Th. and J. Bohm in "Kristallzüchtung", Ed. K.-Th. Wilke, 1. Auflage ed. VEB Deutscher Verlag der Wissenschaften, 1973, 1-922). Es sind 3 aktive Widerstandsheizer Deckelheizer 20a, als Mantelheizer eingerichtete Vorrichtungen 21a zur Erzeugung magnetischer Wanderfelder und Bodenheizer 20b vorgesehen.

Zwischen dem Deckel- und dem Bodenheizer wird der Temperaturgradient eingestellt, die Vorrichtung 21a wirkt wie beim konventionellen Mantelheizer 21 wie oben beschrieben radialen Wärmeflüssen entgegen. Innerhalb dieser Heizeranordnung sind mehrere Tiegel mit Durchmessern von z.B. 3x200 mm, 4x150 mm, 6x125 mm, 12x100 mm oder 12x75 mm vorgesehen (vgl. Fig. 4-9). Die Tiegel 14 sind - wie in den anderen Ausführungsbeispielen auch - in symmetrischer Konfiguration positioniert.

In dieser Anordnung 1 wird nun der Magnetfeldheizer 21a derart eingerichtet, dass die Form der Phasenfront bezüglich der Achse 18 jedes Einzeltiegels symmetrisiert wird (siehe Fig. 6). Magnetfeldheizer 21a sind beispielsweise in der Druckschrift WO 2005/041278 A2 beschrieben. Innerhalb eines Hochdruckkessels 8 sind demnach Graphitstäbe spiralförmig um einen Tiegel gewunden, so dass sie drei Abschnitte ausbilden, die je eine Spule repräsentieren. Mit phasenverschobener Spannung beaufschlagt (Drehstrom) sorgen diese Spulen für geeignete magnetische Wanderfelder. Eine zusätzliche Versorgung mit Gleichstrom stellt in den Spulen eine Widerstandsheizung sicher.

Für die erfindungsgemäße Ausführungsform wird ein Magnetfeldheizer des beschriebenen Typs so realisiert, dass er die symmetrische Anordnung von Tiegeln in ihrer Gesamtheit innerhalb des Hochdruckkessels umgibt, also gerade nicht einzelne Tiegel. Diese Anordnung ist allerdings auf Fälle begrenzt, bei denen die Tiegel auf höchstens einem Kreis um die Symmetrieachse der Tiegelanordnung konfiguriert sind. Ein weiterer Tiegel kann sich mit Vorteil zusätzlich im Symmetriezentrum (in der Mitte) der Anlage befinden.

Zusätzlich kann statt des zentralen Tiegels eine weitere Magnetfeldanordnung (Magnetfeldheizer 21b) zur Unterstützung bzw. Dämpfung des äußeren Magnetfeldes eingebracht werden, um die Phasengrenzen zusätzlich zu beeinflussen. Eine ähnliche Anordnung 1 ist in Fig. 11 gezeigt (dort außen mit konventionellem Mantelheizer 21 oder alternativ mit Magnetfeldheizer 21a). Dabei kann also die Erzeugung des Magnetfeldes ganz oder auch nur teilweise von der inneren bzw. äußeren Magnetfeldanordnung übernommen werden.

In den äußeren Tiegeln (vgl. Fig. 5) treibt das rotierende (wandernde) magnetische Feld (RMF) in der Größenordnung von einigen mT eine Konvektionsrolle 35 (vgl. Fig. 10, 11), die einen zusätzlichen Wärmetransport in der Schmelze 16a oberhalb des erstarrten Materials 16b verursacht. Dieser Wärmestrom kann so dimensioniert werden, dass er einer asymmetrischen Ausbildung der Phasengrenze 33 entgegenwirkt. Die asymmetrische Ausbildung käme ansonsten durch eine stärkere Gaskonvention im mittleren Zwischenraum 23 der Anordnung 1 als im Vergleich zu einem schmalen Raum etwa zwischen Tiegel und äußerem Mantelheizer zustande.

In vielen Materialien sind strukturelle Perfektion und elektrische Homogenität sich widersprechende Eigenschaften. Dies ist im wesentlichen der allgemein bekannten Wechselwirkung zwischen extrinsischen und intrinsischen Punktdefekten, die für elektrische und optische Materialeigenschaften verantwortlich sind, und Strukturdefekten wie z.B, Versetzungen bzw. Korngrenzen zuzuschreiben. Hier wird eine Mikrosegregation beobachtet. Sind nun die Strukturdefekte sehr dicht, dann sind die Konzentrationsinhomogenitäten klein und die Homogenität der elektrischen bzw. optischen Eigenschaften groß. Im umgekehrten Falle sind die mittleren Abstände zwischen Strukturdefekten so groß, dass in Folge der Mikrosegregation relativ große Konzentrationsunterschiede für Punktdefekte auftreten. Im Folgenden werden einige bekannte Messmethoden für wesentliche Eigenschaften der durch die Anordnung gewonnenen Einkristalle und deren Homogenität beschrieben:

Zu den die elektrischen Eigenschaften beschreibenden Parametern zählen der spezifische elektrische Widerstand p und die Störstellendichte des EL2-Niveaus.

Die ortsaufgelöste Messung des spezifischen elektrischen Widerstandes p ist mit der sogenannten COREMA (COntactless REsistivity MApping) möglich (Jantz, W. and Stibal, R. in: "Contactless resistivity mapping of semi-insulating substrates. III-Vs Review 6[4], 38-39. 1993; und Stibal, R., Wickert, M., Hiesinger, P., and Jantz, W. in "Contactless mapping of mesoscopic resistivity variations in semi-insulating substrates", Materials Science and Engineering B 66[1-3], 21-25, 1999). Die typische Ortsauflösung des Verfahrens liegt im Bereich von 1 mm$^2$, das Mapping ist vollflächig.

Die laterale Verteilung der beim GaAs besonders wichtigen Störstellen EL2 kann mit einer ortsaufgelösten Transmissionsmessung bei 1000 nm Wellenlänge gemessen werden (Wickert, M., et al. in "High Resolution EL2 and Resistivity Topography of SI GaAs Wafers", IEEE Inc., 1998, V 21-24; Wickert, M., et al. in "Comparative High Resolution EL2 and Resistivity Topography of Semi-Insulating GaAs Wafers", June 1, 1998 Piscataway, NJ: IEEE Inc., 1999).

Auch die mechanischen Restspannungen von Wafern spielen bei der Weiterverarbeitung eine große Rolle. Sie entstehen, wenn die thermoelastischen Spannungen beim Abkühlen der Kristalle bei erhöhten Temperaturen durch die Bildung von Versetzungen relaxieren. Es ist klar, dass die bei Raumtemperatur gemessene Restspannung wesentlich von der Beschaffenheit des Temperaturfeldes während der Züchtung und des Abkühlens des Kristalls abhängt. Die Restspannungen eines Wafers können mittels Depolarisation von polarisiertem Licht in einem verspannten Medium gemessen werden. In "Photoelastic characterization of residual stress in GaAs-Wafers", H.D. Geiler et al., Materials and Science in Semiconductor Processing 9, (2006) p.345-350 wird eine Methode zur ortsaufgelösten Messung dieser Depolarisation beschrieben, die es erlaubt Restspannungskomponenten zu messen. Alle hier angegebenen Werte sind nach dieser Methode ermittelt worden.

Ein mit der Restspannung zusammenhängender Parameter ist die Versetzungsdichte bzw. die Dichte von Korngrenzen. Sie kann beispielsweise durch die Ätzgrubendichte (*epd*, etch pit density) repräsentiert sein. Dabei wird die glatte Waferoberfläche einem Ätzmaterial aus KOH ausgesetzt, wobei an den Durchstoßpunkten der Versetzungen Gruben (pits) in die Oberfläche geätzt werden, die zur Bestimmung der Flächendichte gezählt werden können.

Die Bestimmung der Standardabweichungen erfolgte nach folgendem mathematischem Schema (am Beispiel des spezifischen elektrischen Widerstands p):

Die Messdaten der Punkte wurden aufgeteilt: für jeden Punkt (x,y) in der Waferebene (der gezüchtete Kristall musste dazu zersägt werden) wurde eine Regressionsebene errechnet aus den Messdaten solcher benachbarter Punkte, die im Inneren eines Umkreises mit dem Radius $\zeta$ von ihm liegen:

$$\rho_{measured} = \rho_{regression\ plane} + \rho_{variation}$$

Der gemessene Widerstand wird dann als Summe zweier Summanden ausgedrückt. Dabei ist $\rho_{regression\ plane}$ der Wert der Regressionsebene im Punkt (x,y) und $\rho_{variation}$ bezeichnet den Abstand zwischen dem Funktionswert der Regressionsebene und dem gemessenen Wert.

Ein least-squares-fit einer Ebene p(x,y) =a+bx+cy für N Datenpunkte kann eineindeutig durch die Lösung des linearen Gleichungssystems

$$\begin{pmatrix} N & \sum x_i & \sum y_i \\ \sum x_i & \sum x_i^2 & \sum x_i y_i \\ \sum y_i & \sum x_i y_i & \sum y_i^2 \end{pmatrix} \begin{pmatrix} a \\ b \\ c \end{pmatrix} = \begin{pmatrix} \sum \rho_i \\ \sum x_i \rho_i \\ \sum y_i \rho_i \end{pmatrix}$$

erhalten werden. Für die Homogenitäten auf verschiedenen Längenskalen können nun dienen:

die totale Standardabweichung:

$$\sigma_{total} = \sqrt[2]{\frac{\sum_{i=1}^{N}(\rho_i - \overline{\rho})^2}{N-1}} \text{ mit } \overline{\rho} = \frac{1}{N}\sum_{i=1}^{N}\rho_i \ ;$$

die lokale Standardabweichung: $\sigma_{lokal} = \sqrt[2]{\dfrac{\sum_{i=1}^{N}(\rho_i - \rho_{p_i})^2}{N-1}}$ , mit $\rho_{p_i}$ als Funktionswert der Regressionsebene

im Punkt ($x_i$,$y_i$); und

die globale Standardabweichung:

$$\sigma_{global} = \sqrt[2]{\frac{\sum_{i=1}^{N}(\rho_{p_i} - \overline{\rho}_p)^2}{N-1}} \text{ , mit } \overline{\rho}_p = \frac{1}{N}\sum_{i=1}^{N}\rho_{p_i} \ .$$

Zu einer genaueren Betrachtung wird die Meßgröße (der Parameter) auf verschiedenen Längenskalen untersucht. Als lokal wird vorliegend etwa ein Bereich in der Größenordnung weniger Versetzungszellen bzw. Körner(der Radius $\zeta$ beträgt 5 - 10 mm) bezeichnet. Als global werden Schwankungen über den gesamten Wafer mit einer minimalen Auflösung des Radius $\zeta$ bezeichnet. Die Schwankungen auf unterschiedlichen Längenskalen können auf physikalisch unterschiedlichen Ursachen beruhen.

Für die getrennte Betrachtung lokaler und globaler Schwankungen einer Messgröße (des gemessenen Parameters) ist die Messung von Mappings mit hoher lateraler Auflösung erforderlich. Meßfelder, die einen geringeren Abstand zum Waferrand als der Randausschluss besitzen, werden in der Auswertung nicht berücksichtigt.

Es können gemäß der hier vorgeschlagenen Betrachtungsweise zwei Größen festgelegt werden: ein Randausschluss und eine charakteristische Länge $\zeta$, danach ist die numerische Berechnung der Größen eindeutig festgelegt und durch jedermann zu reproduzieren.

Alternativ zur vorgeschlagenen Betrachtung ist aber auch eine Fourierfilterung möglich.

Es wurde nun herausgefunden, dass durch die Erfindung besonders hervorragende Eigenschaften der erhaltenen Kristalle hinsichtlich der Homogenität sowohl der elektrischen wie auch der mechanisch-strukturellen Parameter erreicht werden. Und zwar gilt dies insbesondere für globale (nichtlokale) Schwankungen über den Wafer hinweg.

Beim COREMA-Mapping des spezifischen elektrischen Widerstands p wird nun die globale Schwankung durch eine langsame Variation des Defekthaushaltes bestimmt, während lokale Schwankungen durch eine Variation der El2 Störstellenkonzentration mit der Versetzungsstruktur bestimmt sind. Da die globalen Schwankungen größer sind als die lokalen, ist die Standardabweichung über alle Messwerte des spezifischen elektrischen Widerstands eher ein Maß für die globale Variation. Lokale Schwankungen wurden daher bisher kaum betrachtet.

Bei der Bestimmung der Ätzgrubendichte epd hängt die Standardabweichung über alle Messwerte sehr empfindlich von der Messfeldgröße ab. Die Variation von Messfeld zu Messfeld ist sehr groß, so dass im Gegensatz zum COREMA-Mapping die Standardabweichung über alle Werte die lokale Fluktuation angibt. Hier wurde daher bisher die globale Variation kaum betrachtet.

Die Verteilungen von Scherspannungen eines Wafers (senkrecht zur Kristallachse geschnitten) mit SIRD gemessen kann statistisch ausgewertet werden. Dabei ergibt sich eine Lorentzverteilung, die symmetrisch um Null liegt. Die Halbwertsbreite der Verteilung kann als Maß der lokalen Verspannung des Materials interpretiert werden.

Als Messresultate für die Widerstandshomogenität wurden folgende Werte der Standardabweichung - bezogen auf einen Mittelwert für den Widerstand - für einen 6"-VGF-Wafer erhalten:

$$\sigma_\rho \text{ total} = 6,5\%$$
$$\sigma_\rho \text{ global} = 5,3\%$$
$$\sigma_\rho \text{ lokal} = 2,5\%$$

Für spezielle erfindungsgemäße Anordnungen erhielt man sogar folgende Werte:

$$\sigma_\rho \text{ total} = 4,5\%$$
$$\sigma_\rho \text{ global} = 2,8\%$$
$$\sigma_\rho \text{ lokal} = 1,25\%$$

Alle Messungen wurden mit 200x200 Punkten Auflösung, einer Mittelung über $\zeta = 10$ mm und einem Randausschluss von 3 mm durchgeführt.

Bezüglich der Homogenität der epd-Auszählung (Ätzgrubendichte) wurden nun folgende Standardabweichungen (wie oben relativ zu einem Mittelwert) bestimmt:

$$\sigma_{epd} \text{ total} = 90\%$$
$$\sigma_{epd} \text{ global} = 23\%$$
$$\sigma_{epd} \text{ lokal} = 86\%$$

Für spezielle erfindungsgemäße Anordnungen erhielt man sogar folgende Werte:

$$\sigma_{epd} \text{ total} = 76,0\%$$
$$\sigma_{epd} \text{ global} = 17,6\%$$
$$\sigma_{epd} \text{ lokal} = 67,0\%$$

Eine Mittelung wurde hier über $\zeta = 5$ mm mit einem Randausschlussbereich auf dem Wafer von 3 mm durchgeführt. Das Mapping erfolgte (vollflächig) auf Flächen der Größe 500x500 $\mu$m. Es wurde auch die Homogenität der EL2-Störstellendichte für 6" VGF-Wafer bestimmt. Dazu wurden 256 Detektoren linear auf 7,5 mm breiten Streifen angeordnet. Das Mapping wurde vollflächig ausgeführt. Als Randausschluss wurde ein Streifen von 3 mm festgelegt. Die Schrittweite in x-Richtung betrug 570 $\mu$m. In y-Richtung wurde die Auflösung durch bilden des arithmetischen Mittels angepasst. Dabei wurden 21 Streifen à 256 Messpunkte, also N = 5376 Datenpunkte in y-Richtung erhalten. Jeweils k(i) aufeinander folgende Werte werden durch Mittelwertbildung zusammengefasst:

```
k(i) = floor(i*256/N) - floor((i-1)*256/N), i=1…N
```

Die Funktion floor(x) entspricht der Gaußklammer.

Folgende Werte wurden für die Standardabweichung (in Prozent bezogen auf den Mittelwert) erhalten:

```
σ_El2 total = 10,7 %.
```

Für die lokalen und globalen Werte ergab sich relativ dazu:

```
σ_El2 global < 0.8* σ_El2 total
```

$$\sigma_{El2}\ \text{lokal} < 0.7* \ \sigma_{El2}\ \text{total}$$

Eine Mittelung wurde hier über $\zeta = 10$ mm mit einem Randausschlussbereich auf dem Wafer von 3 mm durchgeführt.

Ferner wurde auch die durch eine erfindungsgemäße Anordnung erhaltene Homogenität bezüglich des Rocking-Kurven-Mappings bestimmt. Die Rockingkurvenmappings werden mit einem kommerziell erhältlichen, hochauflösenden Röntgendiffraktometer aufgenommen, welches mit Cu-K$\alpha_1$ Strahlung sowie eingangsseitig mit einer kollimierenden Optik arbeitet. Die Schrittweite in $\omega$ ist so gewählt, dass in der Halbwertsbreite mindestens 6 Messpunkte liegen, d.h. sie beträgt maximal 1,5 arcsec. Bei der Messung auf der Probenoberfläche wird der {004} Reflex (Rockingrichtung <110>) verwendet und die Schrittweite in x- und y-Richtung beträgt höchstens 2x2 mm. Mindestens 2000 Counts sind im Maximum zugrunde gelegt. Die lateralen Abmessungen des Röntgenfokus liegen bei $\leq 1$ mm (Streuebene) bzw. 2 mm (senkrecht zur Streuebene) auf der Oberfläche. Der Randausschlussbereich betrug 2 mm vom Waferrand. Die Bestimmung der Halbwertsbreite (FWHM) fand ohne Korrektur der Auflösungsfunktion statt.

Die Verteilung der Rockingkurven-Linienbreiten fand den Messergebnissen zufolge ihr Maximum bei etwa 10 arcsec. Die Halbwertsbreite der Verteilung von gemessenen Halbwertsbreiten betrug etwa 1 arcsec (etwa 10 Prozent). Weniger als 1 Promille der Halbwertsbreiten überschritt 15 arcsec. Die maximal gemessene Halbwertsbreite lag bei unter 18 arcsec (Bogensekunden).

Folgende Werte wurden für die Standardabweichung (in Prozent bezogen auf den Mittelwert) erhalten:

$$\sigma_{FWHM}\ \text{total} = 7,0\ \%.$$

Für die lokalen und globalen Werte ergab sich relativ dazu:

$$\sigma_{FWHM}\ \text{global} < 0.8*\ \sigma_{FWHM}\ \text{total}$$

$$\sigma_{FWHM}\ \text{lokal} < 0.6*\ \sigma_{FWHM}\ \text{total}$$

Eine Mittelung wurde hier über $\zeta = 10$ mm mit einem Randausschlussbereich auf dem Wafer von 2 mm durchgeführt.

Ferner wurden die Scherspannungen von erfindungsgemäß hergestellten Kristallen bestimmt. Mit einem Randausschluss von 2 mm und einer Messauflösung von 200 $\mu$m x 200 $\mu$m ergaben sich für eine Anpassung einer Lorentzverteilung Halbwertsbreiten von kleiner als 100 kPa und für spezielle Anordnungen von kleiner als 65 kPa.

**Patentansprüche**

1. Kristall aus Galliumarsenid, welcher
eine Verteilung der Versetzungsdichte aufweist und bei dem eine globale Standardabweichung ($\sigma_{global}$) einer die Versetzungsdichte repräsentierenden Ätzgrubendichte (epd) in einer Ebene senkrecht zur Längsachse des Kristalls weniger als 23 % von einem mittleren Wert der Ätzgrubendichte für den Kristall beträgt,
wobei der Bestimmung der globalen Standardabweichung eine charakteristische Länge von 5 mm zugrunde liegt,
wobei die charakteristische Länge die minimale laterale Auflösung eines Mappings repräsentiert,
wobei der Durchmesser 4" oder mehr beträgt.

2. Kristall nach Anspruch 1, bei dem die globale Standardabweichung ($\sigma_{global}$) der die Versetzungsdichte repräsentierenden Ätzgrubendichte (epd) in einer Ebene senkrecht zur Längsachse des Kristalls weniger als 17,6 % von einem mittleren Wert der Ätzgrubendichte für den Kristall beträgt.

3. Kristall aus Galliumarsenid, welcher eine Verteilung des spezifischen elektrischen Widerstands aufweist und bei dem eine globale Standardabweichung ($\sigma_{global}$) in einer Ebene senkrecht zur Längsachse des Kristalls weniger als 5.3 % von einem mittleren Wert des spezifischen elektrischen Widerstands für den Kristall beträgt,
wobei der Bestimmung der globalen Standardabweichung eine charakteristische Länge von 10 mm zugrunde liegt,
wobei die charakteristische Länge die minimale laterale Auflösung eines Mappings repräsentiert,

wobei der Durchmesser 4" oder mehr beträgt.

**4.** Kristall nach Anspruch 3, bei dem die globale Standardabweichung ($\sigma_{global}$) in einer Ebene senkrecht zur Längsachse des Kristalls weniger als 2.8 % von dem mittleren Wert des spezifischen elektrischen Widerstands für den Kristall beträgt.

**5.** Kristall gemäß einer Kombination der Merkmale aus Anspruch 1 oder 2 mit denjenigen aus einem der Ansprüche 3 oder 4.

**6.** Kristall gemäß einem der Ansprüche 1 bis 5, bei dem die globale Standardabweichung für eine EL2-dichte weniger als 8,5 % beträgt.

**7.** Kristall gemäß einem der Ansprüche 1 bis 6, bei dem die globale Standardabweichung einer Verteilung von Halbwertsbreiten der Rockingkurvenlinien in einer Ebene senkrecht zur Längsachse des Kristalls weniger als 5,6 % des Mittelwertes der Verteilung von Halbwertsbreiten der Rockingkurvenlinien beträgt, wobei der Bestimmung der globalen Standardabweichung eine charakteristische Länge von 10 mm zugrunde liegt.

**8.** Kristall gemäß einem der Ansprüche 1 bis 7, bei dem die Versetzungsdichte im kristallinen Material gleich Null oder weniger als 100 je cm$^2$ beträgt.

**9.** Kristall gemäß einem der Ansprüche 1 bis 8, bei dem bei dem die Halbwertsbreite einer Lorentzverteilung von Scherspannungen in dem Kristall weniger als 100 kPa beträgt.

**10.** Kristall gemäß Anspruch 9, bei dem bei dem die Halbwertsbreite einer Lorentzverteilung von lokalen Scherspannungen in dem Kristall weniger als 65 kPa beträgt.

**11.** Kristall gemäß einem der Ansprüche 1 bis 10, bei dem der Kristall ein Einkristall ist.

**Claims**

**1.** Gallium arsenide crystal, comprising:

a distribution of the dislocation density, and in which a global standard deviation ($\sigma_{global}$) of an etch pit density (epd) representing the dislocation density in a plane perpendicular to the longitudinal axis of the crystal amounts to less than 23 % of a mean value of the etch pit density of the crystal, wherein the determination of the global standard deviation is based on a characteristic length of 5 mm, wherein the characteristic length represents the lateral minimum resolution of a mapping, wherein the diameter amounts to 4", or more.

**2.** Crystal according to Claim 1, wherein the global standard deviation ($\sigma_{global}$) of the etch pit density (epd) representing the dislocation density in a plane perpendicular to the longitudinal axis of the crystal amounts to less than 17.6 % of a mean value of the etch pit density of the crystal.

**3.** Gallium arsenide crystal, comprising
a distribution of the specific electrical resistance, and in which a global standard deviation ($\sigma_{global}$) in a plane perpendicular to the longitudinal axis of the crystal amounts to less than 5.3 % of a mean value of the specific electrical resistance of the crystal, wherein the determination of the global standard deviation is based on a characteristic length of 10 mm, wherein the characteristic length represents a lateral minimum resolution of a mapping, wherein the diameter amounts to 4" or more.

**4.** Crystal according to Claim 3, wherein the global standard deviation ($\sigma_{global}$) in a plane perpendicular to the longitudinal axis of the crystal amounts to less than 2.8 % of a mean value of the specific electrical resistance of the crystal.

**5.** Crystal according to a combination of the features of Claims 1 or 2 with those of Claims 3 or 4.

**6.** Crystal according to one of Claims 1 through 5, in which the global standard deviation of an EL2-density amounts to less than 8.5 %.

**7.** Crystal according to one of Claims 1 through 6, in which the global standard deviation of a distribution of the full width at half maximum of the rocking curve lines in a plane perpendicular to the longitudinal axis of the crystal amounts to less than 5.6 % of the mean value of the distribution of full width at half maximum of the rocking curve lines, wherein the determination of the global standard deviation is based on a characteristic length of 10 mm.

**8.** Crystal according to one of Claims 1 through 7, in which the dislocation density in the crystalline material amounts to zero, or less than 100 per cm$^2$.

**9.** Crystal according to one of Claims 1 through 8, in which the full width at half maximum of a Lorentz distribution of the shear stress in the crystal amounts to less than 100 kPa.

**10.** Crystal according to Claim 9, in which the full width at half maximum of a Lorentz distribution of the local shear stress in the crystal amounts to less than 65 kPa.

**11.** Crystal according to one of Claims 1 through 10, in which the crystal is a single crystal.

**Revendications**

**1.** Cristal d'arséniure de gallium, lequel comporte
une distribution de la densité de dislocation et dans lequel un écart type global ($\sigma_{global}$) d'une densité de piqûres de corrosion (epd), représentant la densité de dislocation, dans un plan perpendiculaire à l'axe longitudinal du cristal est égal à moins de 23 % d'une valeur moyenne de la densité des piqûres de corrosion pour le cristal,
dans lequel la détermination de l'écart type global est basée sur une longueur caractéristique de 5 mm, ladite longueur caractéristique représentant la résolution latérale minimale d'un mappage,
le diamètre mesurant 4" ou plus.

**2.** Cristal selon la revendication 1, dans lequel l'écart type global ($\sigma_{global}$) de la densité de piqûres de corrosion (epd), représentant la densité de dislocations, dans un plan perpendiculaire à l'axe longitudinal du cristal est égal à moins de 17,6 % d'une valeur moyenne de la densité des piqûres de corrosion pour le cristal.

**3.** Cristal d'arséniure de gallium, lequel comporte une distribution de la résistance électrique spécifique et dans lequel un écart type global ($\sigma_{global}$) dans un plan perpendiculaire à l'axe longitudinal du cristal est égal à moins de 5,3 % d'une valeur moyenne de la résistance électrique spécifique pour le cristal,
dans lequel la détermination de l'écart type global est basée sur une longueur caractéristique de 10 mm, ladite longueur caractéristique représentant la résolution latérale minimale d'un mappage,
le diamètre mesurant 4" ou plus.

**4.** Cristal selon la revendication 3, dans lequel l'écart type global ($\sigma_{global}$) dans un plan perpendiculaire à l'axe longitudinal du cristal est égal à moins de 2,8 % de la valeur moyenne de la résistance électrique spécifique pour le cristal.

**5.** Cristal selon une combinaison des caractéristiques issues de la revendication 1 ou 2 avec celles de l'une des revendications 3 ou 4.

**6.** Cristal selon l'une quelconque des revendications 1 à 5, dans lequel l'écart type global pour une densité EL2 est inférieur à 8,5 %.

**7.** Cristal selon l'une quelconque des revendications 1 à 6, dans lequel l'écart type global d'une distribution des largeurs à mi-hauteur des courbes de mesure en balancement dans un plan perpendiculaire à l'axe longitudinal du cristal est égal à moins de 5,6 % de la valeur moyenne de la distribution des largeurs à mi-hauteur des courbes de mesure en balancement, la détermination de l'écart type global étant basée sur une longueur caractéristique de 10 mm.

**8.** Cristal selon l'une quelconque des revendications 1 à 7, dans lequel la densité de dislocation dans le matériau cristallin est égale à zéro ou est inférieure à 100 par cm$^2$.

9. Cristal selon l'une quelconque des revendications 1 à 8, dans lequel la largeur à mi-hauteur d'une distribution de Lorentz des sollicitations de cisaillement dans le cristal est inférieure à 100 kPa.

10. Cristal selon la revendication 9, dans lequel la largeur à mi-hauteur d'une distribution de Lorentz des sollicitations de cisaillement locales dans le cristal est inférieure à 65 kPa.

11. Cristal selon l'une quelconque des revendications 1 à 10, dans lequel le cristal est un monocristal.

Fig. 1

Fig. 2

Fig. 3

Fig. 4

Fig. 5

Fig. 6

Fig. 7

Fig. 8

Fig. 9

Fig. 10

Fig. 11

Fig. 12

Fig. 13

Fig. 14

Fig. 15

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 3796552 A
- EP 0130865 A1
- EP 1147248 A
- US 6712904 B
- WO 2005041278 A2

**In der Beschreibung aufgeführte Nicht-Patentliteratur**

- **WILKE, K.-TH. ; J. BOHM.** Kristallzüchtung. VEB Deutscher Verlag der Wissenschaften, 1973, 1-922
- **FLADE et al.** State of the art 6'' SI GaAs wafers made of conventionally grown LEC-crystals. *Journal of Crystal Growth,* 1999, vol. 198/199, 336-342
- Low dislocation density 3-inch Si doped GaAs crystals by Vertical Boat Growth. **HAGI et al.** Semiconducting and Semi-insulating Materials Conference. IEEE, 03. Mai 1996, vol. 29.4, 279-282
- **A.G. FISCHER.** *J. of Electr. Chem. Society,* 1970, (4
- **S.E. BLUM et al.** *Brief Communications of the Electr. Chem. Society,* 1972, (4
- **JANTZ, W ; STIBAL, R.** Contactless resistivity mapping of semi-insulating substrates. *III-Vs Review,* 1993, vol. 6 (4), 38-39
- **STIBAL, R. ; WICKERT, M. ; HIESINGER, P. ; JANTZ, W.** Contactless mapping of mesoscopic resistivity variations in semi-insulating substrates. *Materials Science and Engineering,* 1999, vol. B 66 (1-3), 21-25
- **WICKERT, M. et al.** High Resolution EL2 and Resistivity Topography of SI GaAs Wafers. IEEE Inc, 1998, vol. 21-24
- **WICKERT, M. et al.** Comparative High Resolution EL2 and Resistivity Topography of Semi-Insulating GaAs Wafers. IEEE Inc, 01. Juni 1998
- **H.D. GEILER et al.** Photoelastic characterization of residual stress in GaAs-Wafers. *Materials and Science in Semiconductor Processing,* 2006, vol. 9, 345-350